# EUROPEAN PATENT APPLICATION

(11) **EP 4 576 454 A1**
(43) Date of publication of application: **25.06.2025**
(21) Application number: 23861977.9
(22) Date of filing: 25.06.2023
(51) Int. Cl.: H01S 5/02345

(54) **CASE PACKAGE, PACKAGING ASSEMBLY, AND LIDAR TRANSMITTING MODULE**

(30) Priority: 05.09.2022 CN 202211079927
(71) Applicant: Huawei Technologies Co., Ltd., Shenzhen, Guangdong 518129 (CN)
(72) Inventor: LI, Cunying, Shenzhen, Guangdong 518129 (CN); LIU, Xulei, Shenzhen, Guangdong 518129 (CN); HU, Hao, Shenzhen, Guangdong 518129 (CN)
(74) Representative: Gill Jennings & Every LLP
(86) International application number: PCT/CN2023/102130
(87) International publication number: WO 2024/051275

(57) **Abstract**

A tube-housing packaging member (100), a chip tube-housing packaging structure, and a lidar transmit module (30) are provided, and relate to the chip packaging field, to reduce costs. A specific solution is as follows: The tube-housing packaging member (100) includes a cover (120), a substrate (110), and a first electrical connector (130). The substrate (110) is connected to the cover (120), to enclose a sealing cavity (101). The substrate (110) is configured to be connected to a signal transmission component (20) located in the sealing cavity (101). A thermal expansion coefficient of the substrate (110) is the same as a thermal expansion coefficient of the signal transmission component (20). In this way, the first electrical connector (130) may use a copper pillar formed through electroplating or sputtering with low costs, to replace existing high-temperature co-fired ceramics, thereby reducing costs. The substrate (110) may be made of a material such as ceramics, has good heat dissipation, and can reduce internal stress between the substrate (110) and the signal transmission component (20). In addition, a substrate (110) structure and a printed circuit board (22) in the signal transmission component (20) may be formed by using a same material and process, to reduce technological process costs. Alternatively, a die (04) is directly bonded or welded to the substrate (110), and no printed circuit board (22) is required, thereby further reducing costs.

## Description

This application claims priority to Chinese Patent Application No. 202211079927.X, filed with the China National Intellectual Property Administration on September 5, 2022 and entitled "TUBE-HOUSING PACKAGING MEMBER, PACKAGING ASSEMBLY, AND LIDAR TRANSMIT MODULE", which is incorporated herein by reference in its entirety.

### TECHNICAL FIELD

This application relates to the chip packaging field, and in particular, to a tube-housing packaging member, a chip tube-housing packaging structure, and a lidar transmit module.

### BACKGROUND

As chips are applied in a plurality of fields, a plurality of technologies are also derived for chip packaging, for example, a plastic packaging material packaging technology and a tube-housing packaging technology.

Tube-housing packaging has good heat dissipation performance, and power of a tube-housing packaging chip can be maximized at a full temperature. The tube-housing packaging is applicable to a high-power chip, for example, chip packaging in a lidar transmit module.

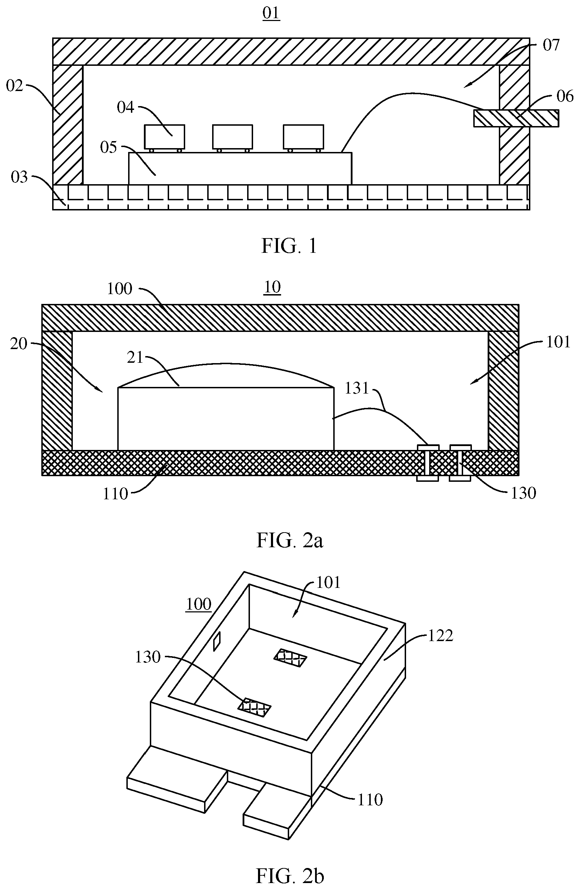

FIG. 1 is a diagram of an internal structure of a chip tube-housing packaging structure 01 in a conventional technology. The chip tube-housing packaging structure 01 includes a housing 02, a bottom plate 03, a die 04, a printed circuit board 05, and a high-temperature co-fired ceramics (High-temperature co-fired ceramics, HTCC) wafer 06. The housing 02 and the bottom plate 03 are connected to each other in a sealed manner to enclose a sealing cavity 07. The die 04 is electrically connected to the printed circuit board 05, the printed circuit board 05 is connected to the bottom plate 03, and both the die 04 and the printed circuit board 05 are located in the sealing cavity 07. The high-temperature co-fired ceramics wafer 06 penetrates the housing 02. The printed circuit board 05 is electrically connected to the high-temperature co-fired ceramics wafer 06 through a bonding wire. The printed circuit board 05 implements signal transmission inside and outside the sealing cavity 07 by using the high-temperature co-fired ceramics wafer 06.

To reduce impact of a temperature change on mechanical reliability of the chip tube-housing packaging structure 01, a material of the bottom plate 03 is usually a material with good heat dissipation performance and a low thermal expansion coefficient, for example, a metal alloy such as WCu or MoCu.

Because costs of a preparation process of the high-temperature co-fired ceramics wafer 06 are high, and costs of the metal-alloyed bottom plate 03 are high, costs of the chip tube-housing packaging structure 01 are high. This hinders application of the chip tube-housing packaging structure 01.

### SUMMARY

Embodiments of this application provide a tube-housing packaging member, a chip tube-housing packaging structure, and a lidar transmit module, to reduce costs of the chip tube-housing packaging structure.

To achieve the foregoing objective, this application uses the following technical solutions.

According to a first aspect, a tube-housing packaging member is provided. The tube-housing packaging member is configured to package a signal transmission component. The tube-housing packaging member includes a cover, a substrate, and a first electrical connector. The substrate is configured to be connected to the cover, to enclose a sealing cavity. The substrate is configured to be connected to the signal transmission component located in the sealing cavity. A thermal expansion coefficient of the substrate is the same as a thermal expansion coefficient of the signal transmission component. The first electrical connector penetrates the substrate. One end of the first electrical connector is configured to be electrically connected to the signal transmission component, and the other end is located outside the sealing cavity. In this way, signal transmission of the signal transmission component is implemented by using the first electrical connector. The first electrical connector may be formed in a low-cost manner such as electroplating, to replace existing high-temperature co-fired ceramics, thereby reducing costs of the tube-housing packaging member. In addition, the thermal expansion coefficient of the substrate is the same as the thermal expansion coefficient of the signal transmission component, so that internal stress between the substrate and the signal transmission component caused by a temperature change can be reduced, and mechanical performance reliability can be improved. The substrate provides excellent heat dissipation performance for the signal transmission component.

With reference to the first aspect, in some implementations, the signal transmission component includes a printed circuit board and a component that are electrically connected to each other, the substrate is configured to be connected to the printed circuit board, one end of the first electrical connector is configured to be electrically connected to the printed circuit board, and the thermal expansion coefficient of the substrate is the same as a thermal expansion coefficient of the printed circuit board. In this way, after a temperature changes, a difference between deformation of the printed circuit board and deformation of the substrate is small, internal stress between the printed circuit board and the substrate is small, a probability of a crack or warping at a joint between the printed circuit board and the substrate is small, and mechanical reliability is high.

With reference to the first aspect, in some implementations, the signal transmission component includes a component. In this way, the tube-housing packaging member may be configured to package the component, and provide a sealing cavity with excellent air tightness for the component, so that a running environment of the component is stable. Mechanical performance between the substrate and the component can be ensured after a use temperature of the component changes.

With reference to the first aspect, in some implementations, a material of the substrate includes at least one of ceramics, glass, and a silicon wafer. The ceramics, the glass, and the silicon wafer have better heat transfer performance, so that the signal transmission component has better heat dissipation performance. Costs of the ceramics, the glass, and the silicon wafer are low. This helps reduce costs of the tube-housing packaging member.

With reference to the first aspect, in some implementations, the ceramics include at least one of AlN, Al₂O₃, SiC, and SiN. A substrate formed by AlN, Al₂O₃, SiC, and SiN has good thermal conductivity. This helps reduce costs of the tube-housing packaging member. In addition, in an embodiment in which the signal transmission component includes a printed circuit board, the printed circuit board and a substrate made of an AlN, Al₂O₃, SiC, or SiN material may be formed by using a similar process, to reduce technological process costs.

With reference to the first aspect, in some implementations, the tube-housing packaging member further includes a first wiring layer, the first wiring layer is connected to an inner surface of the substrate, and the first wiring layer is configured to connect the first electrical connector to the signal transmission component. In this way, the first wiring layer may provide a large quantity of connection paths for interconnection of signal transmission components. In addition, the first wiring layer occupies small space and has a small signal loss. This helps improve electrical performance of the signal transmission component.

With reference to the first aspect, in some implementations, the tube-housing packaging member further includes a bonding wire, the bonding wire is located in the sealing cavity, and the bonding wire is configured to connect the first electrical connector to the signal transmission component. Because a forming process of the bonding wire is simple and costs are low, costs of a packaging assembly are reduced.

With reference to the first aspect, in some implementations, the tube-housing packaging member further includes a second wiring layer, the second wiring layer is connected to an outer surface of the substrate, and the end that is of the first electrical connector and that is located outside the sealing cavity is electrically connected to the second wiring layer. The second wiring layer may implement more cabling paths for the signal transmission component. **In** addition, the second wiring layer occupies small space, and has small impact on a volume of the tube-housing packaging member. **In** addition, a signal of the signal transmission component may be output from a side of the substrate or a bottom of the substrate by using the second wiring layer.

With reference to the first aspect, in some implementations, the tube-housing packaging member further includes a second electrical connector, the substrate has an extension portion located outside the sealing cavity, the second electrical connector penetrates the extension portion, and the second electrical connector is electrically connected to the second wiring layer. **In** this way, a signal of the signal transmission component is transmitted to the second wiring layer by using the first electrical connector, and then transmitted to the second electrical connector by using the second wiring layer. In this way, the signal of the signal transmission component is transmitted to outside of the sealing cavity, and the signal transmission component may be located on a same side of the substrate as the sealing cavity, to avoid a surface that is of the substrate and that is away from the sealing cavity. The surface that is of the substrate and that is away from the sealing cavity may be connected to another structure.

With reference to the first aspect, in some implementations, the tube-housing packaging member further includes an insulation layer, and the insulation layer covers the second wiring layer. In this way, the insulation layer can avoid electrical contact between the second wiring layer and a structure other than the second electrical connector and the first electrical connector, and can avoid a problem such as a short circuit. In addition, the insulation layer can reduce signal interference.

With reference to the first aspect, in some implementations, the tube-housing packaging member further includes a lens, the lens is connected to the cover, and the lens is used to allow an optical signal of the signal transmitter to pass through. In this way, the tube-housing packaging member may be configured to package a signal transmission component with optical signal transmitting or receiving performance, to be applicable to more scenarios, for example, used in a lidar transmit module.

With reference to the first aspect, in some implementations, the cover includes a top plate and an enclosure plate that are connected to each other, the top plate and the substrate are disposed opposite to each other, and the substrate is connected to the enclosure plate. In this way, the top plate and the enclosure plate may be connected to each other after the substrate is connected to the signal transmission component, thereby reducing technological process costs.

With reference to the first aspect, in some implementations, the first electrical connector is formed through electroplating, chemical plating, or sputtering. In this way, there is a low probability that the first electrical connector formed through electroplating, chemical plating, or sputtering has an air hole inside the first electrical connector, and the first electrical connector has a small resistivity and a smooth edge, thereby reducing an electrical signal loss.

According to a second aspect, a packaging assembly is provided. The packaging assembly includes a signal transmission component and any tube-housing packaging member provided in the first aspect. The signal transmission component is located in the sealing cavity. The signal transmission component is electrically connected to the first electrical connector. A thermal expansion coefficient of the signal transmission component is the same as a thermal expansion coefficient of the substrate. In this way, costs of the packaging assembly obtained by packaging the signal transmission component by the tube-housing packaging member are reduced, and mechanical performance is reliable. Excellent heat transfer performance and sealing performance of the tube-housing packaging member well ensure electrical performance reliability of the signal transmission component.

With reference to the second aspect, in some implementations, the signal transmission component is welded or bonded to the substrate. In this way, a process of connecting the signal transmission component to the substrate is simple, and technological process costs are low.

With reference to the second aspect, in some implementations, the packaging assembly further includes a bracket. The bracket is connected to the cover or the substrate. In this way, the cover or the substrate may be supported by using the bracket, to support the tube-housing packaging member.

With reference to the second aspect, in some implementations, the bracket is connected to the substrate through a thermally conductive adhesive. The thermally conductive adhesive may transfer heat on the substrate to the bracket, to provide excellent heat dissipation for the signal transmission component.

According to a third aspect, a lidar transmit module is provided. The lidar transmit module includes any packaging assembly provided in the second aspect. Costs of the lidar transmit module decrease with reduction of costs of the packaging assembly. In addition, excellent heat dissipation performance of the packaging assembly enables an explosion of electrical performance of the lidar transmit module at a high temperature.

### BRIEF DESCRIPTION OF DRAWINGS

FIG. 1 is a diagram of an internal structure of a chip tube-housing packaging structure in a conventional technology;
FIG. 2a is a diagram of a structure of a packaging assembly according to an embodiment of this application;
FIG. 2b is a diagram of an internal structure of a tube-housing packaging member according to an embodiment of this application;
FIG. 2c is a diagram of a structure of another packaging assembly according to an embodiment of this application;
FIG. 3a is a diagram of a structure of a tube-housing packaging member according to an embodiment of this application;
FIG. 3b is a diagram of a structure of another tube-housing packaging member according to an embodiment of this application;
FIG. 3c is a diagram of a structure of still another tube-housing packaging member according to an embodiment of this application;
FIG. 3d is a diagram of a structure of yet another tube-housing packaging member according to an embodiment of this application;
FIG. 4a is an assembly flowchart of a packaging assembly;
FIG. 4b is a diagram of a structure of a substrate present before S1 in FIG. 4a is performed;
FIG. 4c is a diagram of a structure present after S1 in FIG. 4a is performed;
FIG. 4d is a diagram of a structure of an enclosure plate present before welding;
FIG. 4e is a diagram of a structure present after S2 in FIG. 4a is performed;
FIG. 4f is another assembly flowchart of a packaging assembly;
FIG. 4g is a diagram of a structure of a substrate present before S1 in FIG. 4f is performed;
FIG. 4h is a diagram of a structure present after S4 in FIG. 4f is performed;
FIG. 4i is a diagram of a structure present after S3 in FIG. 4f is performed; and
FIG. 5 is a diagram of a structure of a lidar transmit module including the tube-housing packaging member in FIG. 3c.

In the figures: 01: chip tube-housing packaging structure; 02: housing; 03: bottom plate; 04: die; 05: printed circuit board; 06: high-temperature co-fired ceramics wafer; 07: sealing cavity; 10: packaging assembly; 20: signal transmission component; 21: component; 22: printed circuit board; 100: tube-housing packaging member; 101: sealing cavity; 110: substrate; 120: cover; 121: top plate; 122: enclosure plate; 123: lens; 124: plating layer; 125: isolation zone; 130: first electrical connector; 132: first wiring layer; 131: bonding wire; 150: second wiring layer; 111: extension portion; 160: second electrical connector; 170: insulation layer; 140: pin; 31: bracket; 32: thermally conductive adhesive layer; 30: lidar transmit module.

### DESCRIPTION OF EMBODIMENTS

To make the objectives, technical solutions, and advantages of this application clearer, the following further describes this application in detail with reference to the accompanying drawings.

The terms such as "first" and "second" mentioned below are merely intended for a purpose of description, and shall not be understood as an indication or implication of relative importance or implicit indication of a quantity of indicated technical features. Therefore, a feature limited by "first", "second", or the like may explicitly or implicitly include one or more features. In the descriptions of this application, unless otherwise stated, "a plurality of" means two or more than two.

In addition, in this application, position terms such as "upper", and "lower" are defined relative to an illustrative position of a component in the accompanying drawings. It should be understood that these direction terms are relative concepts and are used for relative description and clarification, and may vary accordingly depending on a position change in which components are placed in the accompanying drawings.

Embodiments of this application provide a packaging assembly. A function of the packaging assembly is not limited in embodiments of this application. For example, the packaging assembly may be used in a lidar transmit module or an optical fiber.

FIG. 2a is a diagram of a structure of a packaging assembly 10 according to an embodiment of this application. FIG. 2b is a diagram of an internal structure of a tube-housing packaging member 100 according to an embodiment of this application. Refer to FIG. 2a and FIG. 2b. The packaging assembly 10 includes the tube-housing packaging member 100 and a signal transmission component 20. The tube-housing packaging member 100 is configured to: seal the signal transmission component 20, and connect the signal transmission component 20 to a signal of a signal transmission device outside the tube-housing packaging member 100 through a first electrical connector 130.

The tube-housing packaging member 100 has a sealing cavity 101, and the signal transmission component 20 is located in the sealing cavity 101.

A structure of the signal transmission component 20 is not limited in this embodiment of this application, and may be set based on a function and a use scenario of the packaging assembly 10.

For example, in FIG. 2a, the signal transmission component 20 includes a component 21.

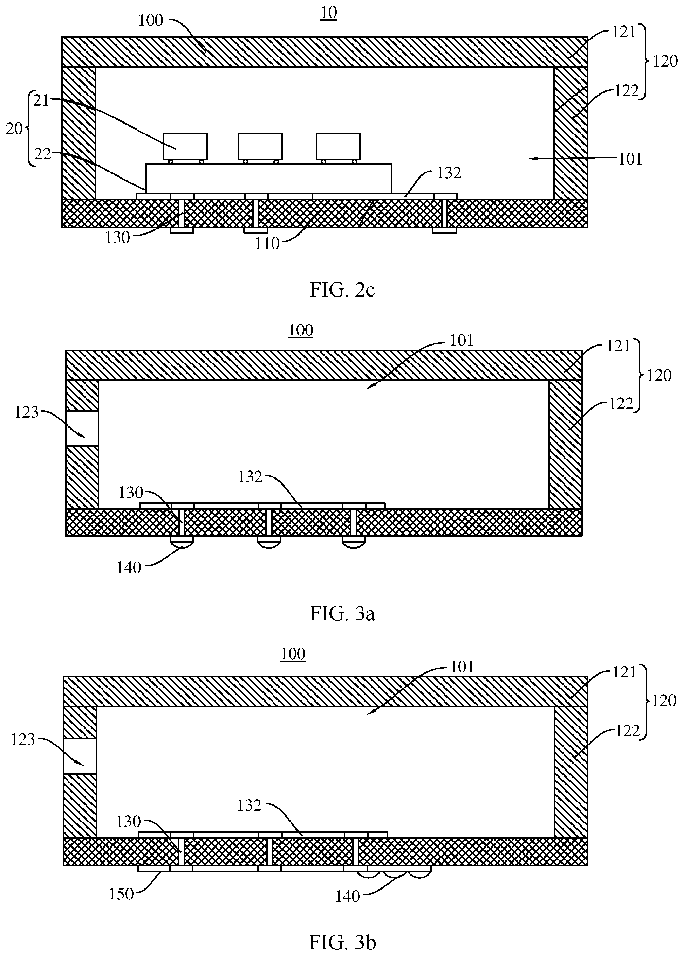

FIG. 2c is a diagram of a structure of another packaging assembly 10 according to an embodiment of this application. In FIG. 2c, a signal transmission component 20 includes a component 21 and a printed circuit board 22. The component 21 is electrically connected to the printed circuit board 22.

Both the component 21 and the printed circuit board 22 are located in a sealing cavity 101.

A quantity of components 21 is not limited in this embodiment of this application, and there may be one or more components 21.

In the example in FIG. 2c, there may be a plurality of components 21.

A connection manner of the component 21 is not limited in this embodiment of this application. For example, as shown in FIG. 2c, the plurality of components 21 are all electrically connected to the printed circuit board 22, and the plurality of components 21 are interconnected through the printed circuit board 22.

In some other embodiments of this application, the plurality of components 21 are interconnected through a conducting wire.

In another embodiment of this application, the plurality of components 21 may alternatively not be connected to each other, and each component 21 is connected only to an external signal transmission device.

A structure of the component 21 is not limited in this embodiment of this application. For example, the component 21 may be a die or an optical fiber component.

In an embodiment in which the component 21 is a die, a structure and a function of the die are not limited in this embodiment of this application, and may be set based on a use scenario of the packaging assembly 10.

FIG. 3a is a diagram of a structure of the tube-housing packaging member 100 according to an embodiment of this application. Refer to FIG. 3a. The tube-housing packaging member 100 includes a substrate 110 and a cover 120. The substrate 110 is connected to the cover 120, and the substrate 110 and the cover 120 enclose the sealing cavity 101.

The substrate 110 is connected to the signal transmission component 20.

A connection manner between the substrate 110 and the signal transmission component 20 is not limited in this embodiment of this application. For example, the substrate 110 is welded to the signal transmission component 20, or the substrate 110 is connected to the signal transmission component 20 through a bonding member.

In this embodiment of this application, a thermal expansion coefficient of the substrate 110 is the same as a thermal expansion coefficient of the signal transmission component 20.

The thermal expansion coefficient of the substrate 110 being the same as the thermal expansion coefficient of the signal transmission component 20 means that in an embodiment in which the thermal expansion coefficient of the signal transmission component 20 or the thermal expansion coefficient of the substrate 110 is anisotropic, in a thickness direction of the substrate 110, the thermal expansion coefficient of the substrate 110 is the same as the thermal expansion coefficient of the signal transmission component 20.

The thermal expansion coefficient of the substrate 110 is the same as the thermal expansion coefficient of the signal transmission component 20. Therefore, after a temperature changes, a difference between deformation of the substrate 110 and deformation of the signal transmission component 20 is small, internal stress between the substrate 110 and the signal transmission component 20 is small, the substrate 110 is in good contact with the signal transmission component 20, and mechanical reliability is good. In addition, good contact facilitates excellent heat transfer between the substrate 110 and the signal transmission component 20, to provide excellent heat dissipation performance for the signal transmission component 20.

For example, in FIG. 2a, the substrate 110 is connected to the component 21, so that the thermal expansion coefficient of the substrate 110 is the same as a thermal expansion coefficient of the component 21.

In some embodiments, the signal transmission component 20 has a plurality of structures, and the thermal expansion coefficient of the substrate 110 is the same as the thermal expansion coefficient of the signal transmission component 20. It may be considered that a thermal expansion coefficient of a component that is closest to the substrate 110 and that is in the signal transmission component 20 is the same as the thermal expansion coefficient of the substrate 110.

For example, in FIG. 2c, the signal transmission component 20 includes the printed circuit board 22 and the component 21 disposed on the printed circuit board 22. Compared with the component 21, the printed circuit board 22 is closer to the substrate 110, so that the thermal expansion coefficient of the substrate 110 is the same as a thermal expansion coefficient of the printed circuit board 22. After an ambient temperature changes, the deformation of the substrate 110 is the same as deformation of the printed circuit board 22, internal stress between the substrate 110 and the printed circuit board 22 is small, a probability of a crack or warping at a joint between the substrate 110 and the printed circuit board 22 is small, and mechanical reliability is high.

In the example shown in FIG. 2c, a relationship between the thermal expansion coefficient of the substrate 110 and the thermal expansion coefficient of the component 21 may not be limited in this embodiment of this application. In some embodiments of this application, the thermal expansion coefficient of the substrate 110 may be the same as the thermal expansion coefficient of the component 21.

It should be noted that, same thermal expansion coefficients are not limited to absolute same in numerical values, and may be close to the same. For example, a difference between the thermal expansion coefficient of the substrate 110 and the thermal expansion coefficient of the signal transmission component 20 is less than 20×10⁻⁶/°C. For example, the difference between the thermal expansion coefficient of the substrate 110 and the thermal expansion coefficient of the signal transmission component 20 is 0, 0.6×10⁻⁶/°C, 2×10⁻⁶/°C, 3×10⁻⁶/°C, 5×10⁻⁶/°C, 6×10⁻⁶/°C, 7×10⁻⁶/°C, 8×10⁻⁶/°C, 9×10⁻⁶/°C, 10×10⁻⁶/°C, 15×10⁻⁶/°C 18×10⁻⁶/°C, or 20×10⁻⁶/°C.

In an embodiment in which the component 21 is a die, a thermal expansion coefficient of the die may be approximately a thermal expansion coefficient of a substrate material of the die. For example, in an embodiment in which a substrate of the die is silicon, the thermal expansion coefficient of the substrate 110 is close to a thermal expansion coefficient of silicon.

A material of the substrate 110 is not limited in this embodiment of this application. The material of the substrate 110 is selected based on the thermal expansion coefficient of the signal transmission component 20.

For example, the material of the substrate 110 includes at least one of ceramics, glass, and a silicon wafer. In this way, the thermal expansion coefficient of the substrate 110 is close to the thermal expansion coefficient of the printed circuit board 22 or the component 21. In addition, the ceramics, the glass, and the silicon wafer have better heat transfer performance, so that the signal transmission component 20 has better heat dissipation performance.

For example, the ceramics include at least one of AlN, Al₂O₃, SiC, and SiN. The AlN, the Al₂O₃, the SiC, and the SiN have good thermal conductivity and costs are low. This helps reduce costs of the tube-housing packaging member 100.

In this embodiment of this application, the tube-housing packaging member 100 needs to implement signal transmission between the signal transmission component 20 and the signal transmission device outside the sealing cavity 101.

As shown in FIG. 3a, the tube-housing packaging member 100 further includes a first electrical connector 130. The first electrical connector 130 penetrates the substrate 110. One end of the first electrical connector 130 is located in the sealing cavity 101, and the other end is located outside the sealing cavity 101.

The end that is of the first electrical connector 130 and that is located in the sealing cavity 101 is electrically connected to the signal transmission component 20. In this way, the first electrical connector 130 implements signal transmission between the signal transmission component 20 in the sealing cavity 101 and outside of the sealing cavity 101. A material of the first electrical connector 130 can be selected from many options, and the material is not limited to high-temperature co-fired ceramics. The first electrical connector 130 may select a material whose costs are far lower than costs of the high-temperature co-fired ceramics. For example, the first electrical connector 130 may use a copper pillar formed through sputtering, chemical plating, electroplating, or the like, or the first electrical connector 130 may be cured and molded by using conductive slurry.

In a high-temperature co-fired ceramics technology, costs are high, a conductor resistivity is high, and a conductor edge is uneven. The first electrical connector 130 formed through sputtering, chemical plating, electroplating, or the like has a small quantity of air holes inside the first electrical connector 130, a smooth surface, a small resistance, and a small electrical signal loss.

The tube-housing packaging member 100 provided in this embodiment of this application implements signal transmission of the signal transmission component 20 by using the first electrical connector 130. The first electrical connector 130 may be formed by using a low-cost process such as electroplating, to replace existing high-temperature co-fired ceramics, thereby reducing costs of the tube-housing packaging member 100. In addition, the thermal expansion coefficient of the substrate 110 is the same as the thermal expansion coefficient of the signal transmission component 20, so that the internal stress between the substrate 110 and the signal transmission component 20 caused by a temperature change can be reduced, and mechanical performance reliability can be improved. The substrate 110 provides excellent heat dissipation performance for the signal transmission component 20. Further, the substrate 110 may be made of a material such as ceramics, and in comparison with a WCu alloy, costs of the tube-housing packaging member 100 may be further reduced.

Apparently, costs of the packaging assembly 10 obtained by packaging the signal transmission component 20 by the tube-housing packaging member 100 are reduced, and mechanical performance is reliable. Excellent heat transfer performance and sealing performance of the tube-housing packaging member 100 well ensure electrical performance reliability of the signal transmission component 20.

A quantity of the first electrical connectors 130 and a distribution position of the first electrical connector 130 on the substrate 110 are not limited in this embodiment of this application.

For example, in an embodiment in which the signal transmission component 20 includes the component 21 and the printed circuit board 22, the end that is of the first electrical connector 130 and that is located in the sealing cavity 101 is electrically connected to the printed circuit board 22.

In some embodiments, an electrical connector that penetrates the printed circuit board 22 may also be disposed on the printed circuit board 22. One end of the electrical connector is electrically connected to the component 21, and the other end is electrically connected to the first electrical connector 130. In this way, the printed circuit board 22 and the substrate 110 may be made of a same material and processed by using a same process, thereby reducing technological process costs.

For example, a via is provided on a surface of the substrate 110, and copper is electroplated in the via to form the first electrical connector 130. Similarly, the printed circuit board 22 may also use a same process route to form an electrical connector.

It may be understood that, in an embodiment in which the signal transmission component 20 includes the component 21 and the printed circuit board 22, both the component 21 and the printed circuit board 22 may be electrically connected to the first electrical connector 130 based on a circuit design and a requirement.

Alternatively, in an embodiment in which the signal transmission component 20 is the component 21, one end that is of the first electrical connector 130 and that is located in the sealing cavity 101 is connected to the component 21.

An electrical connection manner between the first electrical connector 130 and the signal transmission component 20 is not limited in this embodiment of this application.

As shown in FIG. 2a, the first electrical connector 130 is electrically connected to the signal transmission component 20 through a bonding wire 131. Two opposite ends of the bonding wire 131 are respectively electrically connected to the first electrical connector 130 and the signal transmission component 20. Because a forming process of the bonding wire 131 is simple and costs are low, costs of the packaging assembly 10 are reduced.

As shown in FIG. 2c, the first electrical connector 130 is electrically connected to the signal transmission component 20 through a first wiring layer 132. The first wiring layer 132 is located in the sealing cavity 101, and the first wiring layer 132 is connected to an inner surface of the substrate 110. The signal transmission component 20 is electrically connected to the first wiring layer 132, and the end that is of the first electrical connector 130 and that is located in the sealing cavity 101 is electrically connected to the first wiring layer 132.

The first wiring layer 132 occupies small space. This can reduce a volume of the tube-housing packaging member 100. In addition, interconnection and a logical relationship between the plurality of components 21 may be further implemented by using different patterns of the first wiring layer 132. In an embodiment in which the component 21 is a die, a plurality of dies may be interconnected through the first wiring layer 132.

A material of the first wiring layer 132 is not limited in this embodiment of this application. For example, the first wiring layer 132 may be a copper wiring.

In FIG. 2c, there is one first wiring layer 132 and one substrate 110. In another embodiment of this application, there may be a plurality of substrates 110 and a plurality of first wiring layers 132, the substrates 110 and the first wiring layers 132 are stacked, and there is one first wiring layer 132 between two adjacent substrates 110. In this way, a length of a cabling path may be increased, and the plurality of substrates 110 have a signal shielding function.

In an embodiment in which there are a plurality of substrates 110, two adjacent substrates 110 may be bonded through a bonding member.

It may be understood that an electrical connection between the first electrical connector 130 and the signal transmission component 20 is not limited to the foregoing two manners. For example, the first electrical connector 130 and the signal transmission component 20 are electrically connected to each other through the first wiring layer 132 and the bonding wire 131.

It should be noted that, in this embodiment of this application, a structure of the signal transmission component 20 is not associated with the electrical connection manner between the first electrical connector 130 and the signal transmission component 20. In other words, for a same signal transmission component 20, an electrical connection manner between the first electrical connector 130 and the signal transmission component 20 may be randomly selected.

FIG. 3a is described by using an example in which the first electrical connector 130 is electrically connected to the signal transmission component 20 through the first wiring layer 132. A structure in which the first electrical connector 130 is electrically connected to the signal transmission component 20 through the bonding wire 131 is similar. Details are not described herein again.

A forming process of the first electrical connector 130 is not limited in this embodiment of this application. For example, the first electrical connector 130 is formed through sputtering, electroplating, or curing by using conductive slurry.

The material of the first electrical connector 130 is not limited in this embodiment of this application. For example, the material may be copper, silver, or conductive slurry.

A quantity of first electrical connectors 130 is not limited in this embodiment of this application. For example, there are a plurality of first electrical connectors 130, and the plurality of first electrical connectors 130 are distributed at intervals.

In this embodiment of this application, the end that is of the first electrical connector 130 and that is located outside the sealing cavity 101 is electrically connected to a structure such as a power supply. Alternatively, the first electrical connector 130 may be connected to a power supply through another conductive structure.

FIG. 3b is a diagram of a structure of another tube-housing packaging member 100 according to an embodiment of this application. In FIG. 3b, the tube-housing packaging member 100 further includes a second wiring layer 150. For other structures, refer to descriptions of the example in FIG. 3a. Details are not described herein again.

In the example in FIG. 3b, the second wiring layer 150 is connected to an outer surface of a substrate 110, and one end that is of a first electrical connector 130 and that is located outside the sealing cavity 101 is electrically connected to the second wiring layer 150.

A material of the second wiring layer 150 is not limited in this embodiment of this application. For example, the second wiring layer 150 is a copper wiring.

The second wiring layer 150 may implement more cabling paths for the signal transmission component 20. In addition, the second wiring layer 150 occupies small space, and has small impact on a volume of the tube-housing packaging member 100. In addition, a signal of the signal transmission component 20 may be output from a side of the substrate 110 by using the second wiring layer 150, so that there are more options for electrical connection points of the tube-housing packaging member 100.

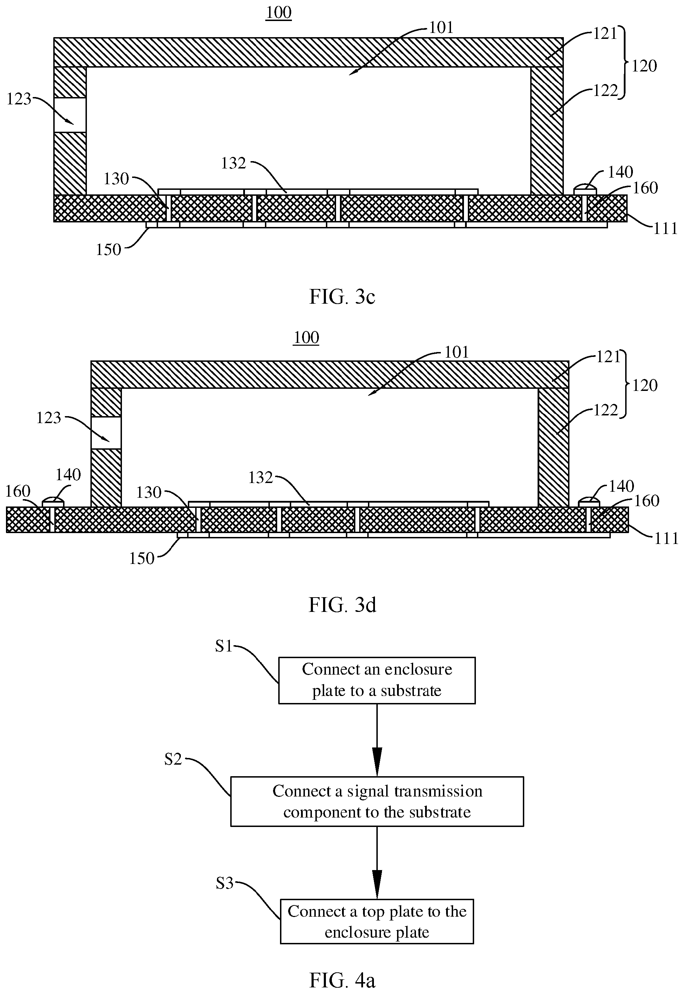

FIG. 3c is a diagram of a structure of still another tube-housing packaging member 100 according to an embodiment of this application. In FIG. 3c, the tube-housing packaging member 100 further includes a second electrical connector 160. For other structures, refer to the description of the example in FIG. 3b. Details are not described herein again.

In the example in FIG. 3c, the substrate 110 has an extension portion 111, and the extension portion 111 is located outside the sealing cavity 101. In other words, a cover 120 does not completely cover the substrate 110, and the cover 120 does not cover the extension portion 111.

The second electrical connector 160 penetrates the extension portion 111, and one end of the second electrical connector 160 is electrically connected to a second wiring layer 150.

A signal of the signal transmission component 20 is transmitted to the second wiring layer 150 by using a first electrical connector 130, and then transmitted to the second electrical connector 160 by using the second wiring layer 150. In this way, the signal of the signal transmission component 20 is transmitted to outside of the sealing cavity 101, and the signal transmission component 20 is located on a same side of the substrate 110 as the sealing cavity 101, to avoid a surface that is of the substrate 110 and that is away from the sealing cavity 101. In this way, the surface that is of the substrate 110 and that is away from the sealing cavity 101 may be connected to another structure.

A position relationship between the extension portion 111 and the sealing cavity 101 is not limited in this embodiment of this application. For example, in FIG. 3c, the extension portion 111 is located on a side of the sealing cavity 101. In this way, the second electrical connector 160 is located on the side of the sealing cavity 101.

Alternatively, FIG. 3d is a diagram of a structure of yet another tube-housing packaging member 100 according to an embodiment of this application. In FIG. 3d, an extension portion 111 is located around the sealing cavity 101. In this way, second electrical connectors 160 may be distributed around the sealing cavity 101.

In another embodiment of this application, second electrical connectors 160 may not be distributed in an entire extension portion 111. For example, the extension portion 111 is located around the sealing cavity 101. The second electrical connector 160 is located on one side of the sealing cavity 101.

For a structure of the second electrical connector 160 in this embodiment of this application, refer to the structure of the first electrical connector 130. Details are not described herein again.

Still refer to FIG. 3c. The tube-housing packaging member 100 further includes an insulation layer 170. The insulation layer 170 covers the second wiring layer 150. In this way, the insulation layer 170 can avoid electrical contact between the second wiring layer 150 and a structure other than the second electrical connector 160 and the first electrical connector 130, and can avoid a problem such as a short circuit. In addition, the insulation layer 170 can reduce signal interference.

In some embodiments of this application, the tube-housing packaging member 100 further includes a pin 140. The pin 140 is located outside the sealing cavity 101. The pin 140 is configured to be connected to the signal transmission device, to implement signal transmission between the signal transmission component 20 and the outside.

As described above, there are a plurality of structures that are in the tube-housing packaging member 100 and that are located outside the sealing cavity 101 and that are used for signal transmission, and the pin 140 is set in a plurality of manners.

As shown in FIG. 3a, the pin 140 is electrically connected to the end that is of the first electrical connector 130 and that is located outside the sealing cavity 101.

As shown in FIG. 3b, the pin 140 is electrically connected to the second wiring layer 150.

As shown in FIG. 3c and FIG. 3d, the pin 140 is electrically connected to one end that is of the second electrical connector 160 and that is away from the second wiring layer 150.

When the packaging assembly 10 is used, the tube-housing packaging member 100 may be mechanically connected to other structures through different parts, for example, the tube-housing packaging member 100 may be connected to another structure through the cover 120, or the tube-housing packaging member 100 may be connected to another structure through the substrate 110. This is set based on the use scenario of the packaging assembly 10 and a position of the pin 140.

In this embodiment of this application, the pin 140 is not necessary, and the pin 140 may not be disposed. For example, the signal transmission device is directly electrically connected to the end that is of the first electrical connector 130 and that is located outside the sealing cavity 101.

In this embodiment of this application, the substrate 110 and the cover 120 are connected to each other after the signal transmission component 20 is placed in the sealing cavity 101. In other words, after the tube-housing packaging member 100 is prepared, the substrate 110 and the cover 120 are in unclosed states, and the sealing cavity 101 is not formed. When the tube-housing packaging member 100 is used to package the signal transmission component 20 or when the packaging assembly 10 is prepared, after the signal transmission component 20 is connected to the tube-housing packaging member 100, the substrate 110 and the cover 120 are connected to each other in a sealed manner to form the sealing cavity 101.

An atmosphere in the sealing cavity 101 is not limited in this embodiment of this application. For example, the sealing cavity 101 is filled with an inert gas, for example, nitrogen or argon. For example, the substrate 110 and the cover 120 are connected to each other in an environment of an inert gas, and an inert atmosphere may be filled in the sealing cavity 101.

A shape of the sealing cavity 101 is not limited in this embodiment of this application. The shape of the sealing cavity 101 may be set based on a shape of the signal transmission component 20. For example, the sealing cavity 101 is a square cavity.

Similarly, a shape of the cover 120 is not limited in this embodiment of this application, and the shape of the cover 120 may be set based on the shape of the signal transmission component 20. For example, the cover 120 is a square cover.

In this embodiment of this application, the cover 120 includes a top plate 121 and an enclosure plate 122. The top plate 121 and the enclosure plate 122 are connected to each other. The top plate 121 and the substrate 110 are disposed opposite to each other, and the substrate 110 is connected to the enclosure plate 122.

In some embodiments of this application, after the tube-housing packaging member 100 is prepared, the substrate 110 and the enclosure plate 122 are in a connected state, the top plate 121 and the enclosure plate 122 are in an unconnected state, and the sealing cavity 101 is not formed. When the tube-housing packaging member 100 is used to package the signal transmission component 20 or when the packaging assembly 10 is prepared, the top plate 121 and the enclosure plate 122 are connected to each other to form the sealing cavity 101.

In some other embodiments of this application, after the tube-housing packaging member 100 is prepared, the substrate 110 and the enclosure plate 122 are in an unconnected state, the top plate 121 and the enclosure plate 122 are in a connected state, and the sealing cavity 101 is not formed. When the tube-housing packaging member 100 is used to package the signal transmission component 20 or when the packaging assembly 10 is prepared, the substrate 110 and the enclosure plate 122 are connected to each other to form the sealing cavity 101.

Materials of the top plate 121 and the enclosure plate 122 are not limited in this embodiment of this application. For example, the top plate 121 and the enclosure plate 122 are metals, a thermal expansion coefficient of the metal enclosure plate 122 is close to the thermal expansion coefficient of the substrate 110, and a joint between the enclosure plate 122 and the substrate 110 is not easily cracked due to internal stress.

For example, in an embodiment in which the material of the substrate 110 is ceramics, the enclosure plate 122 made of a metal material has excellent sealing performance after being welded to the substrate 110, and there are few bubbles in a welding seam, so that the sealing cavity 101 has excellent air tightness.

A manner of welding the enclosure plate 122 to the substrate 110 is not limited in this embodiment of this application. For example, the enclosure plate 122 is welded to the substrate 110 through lead-free solder paste (SAC305), and vacuum reflow soldering may be used as a welding process, so that excellent sealing performance of a joint between the enclosure plate 122 and the substrate 110 can be implemented.

In some embodiments, the materials of the top plate 121 and the enclosure plate 122 are kovar alloys. After the kovar alloy is welded to the substrate 110, internal stress at a welding position is small, and sealing performance at a welding seam is good.

In some embodiments, the materials of the top plate 121 and the enclosure plate 122 may be other materials such as ceramics.

A connection manner between the top plate 121 and the enclosure plate 122 is not limited in this embodiment of this application. For example, the top plate 121 and the enclosure plate 122 are welded, or the top plate 121 and the enclosure plate 122 are integrated.

In FIG. 3a, the tube-housing packaging member 100 further includes a lens 123, and the lens 123 is connected to the cover 120. The lens 123 may be used to allow an optical signal in the sealing cavity 101 to pass through.

In another embodiment of this application, the lens 123 is located on the top plate 121, or the lens 123 is located on the enclosure plate 122. Alternatively, lenses 123 are disposed on both the top plate 121 and the enclosure plate 122.

For example, in an embodiment in which the packaging assembly 10 is used in a lidar transmit module and an optical fiber, the lens 123 is disposed in the tube-housing packaging member 100.

For example, in an embodiment in which the tube-housing packaging member 100 is used in a vertical-cavity surface-emitting laser (vertical-cavity surface-emitting laser, VCSEL), the lens 123 is connected to the top plate 121. In an embodiment in which the tube-housing packaging member 100 is used in an edge-emitting laser (edge-emitting laser, EEL), the lens 123 is connected to the enclosure plate 122.

In this embodiment of this application, the lens 123 is not necessary. The lens 123 may not be disposed on the tube-housing packaging member 100, and is disposed based on the structure of the signal transmission component 20 or the function of the packaging assembly 10.

An assembly process of the packaging assembly 10 is not limited in this embodiment of this application. The following describes an assembly process of the packaging assembly 10 shown in FIG. 2c as an example.

FIG. 4a is an assembly flowchart of the packaging assembly 10. Refer to FIG. 4a. An assembly procedure includes the following steps.

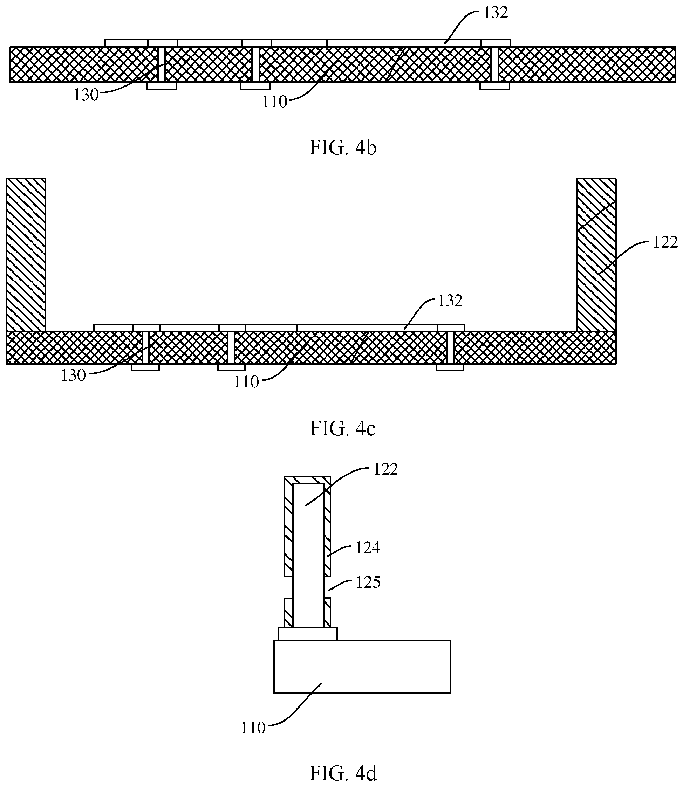

S1: Connect an enclosure plate 122 to a substrate 110 shown in FIG. 4b.

FIG. 4b is a diagram of a structure of the substrate 110 present before S1 in FIG. 4a is performed. As shown in FIG. 4b, before S1, a first electrical connector 130 and a first wiring layer 132 have been prefabricated on the substrate 110. In an embodiment in which the packaging assembly 10 does not include the first wiring layer 132, the first wiring layer 132 shown in FIG. 4b is not provided on a surface of the substrate 110.

FIG. 4c is a diagram of a structure present after S1 in FIG. 4a is performed. A connection manner between the substrate 110 and the enclosure plate 122 is not limited in this embodiment of this application. For example, the substrate 110 is welded to the enclosure plate 122.

For example, vacuum reflow soldering may be used as a welding process, to increase air tightness at a welding seam position. A condition of the reflow welding may be adjusted based on an actual situation, to improve air tightness at the welding seam position. For example, a counterweight block is placed on the enclosure plate 122, so that a welding seam height between the substrate 110 and the enclosure plate 122 is even. Alternatively, an amount of solder paste is controlled, a size of a solder mesh opening for printing solder paste is adjusted, or the like.

Alternatively, in some embodiments, as shown in FIG. 4d, a plating layer 124 is disposed on a surface of the enclosure plate 122, and at a position that is of the enclosure plate 122 and that is close to the substrate 110, there is an isolation zone 125 that is not covered by the plating layer 124. The isolation zone 125 may be formed by removing the plating layer 124 through etching.

The plated isolation zone present after the enclosure plate 122 and the substrate 110 are welded can reduce a climbing height of soldering tin. This can reduce a gap in the welding seam and increase air tightness.

S2: Connect a signal transmission component 20 to the substrate 110.

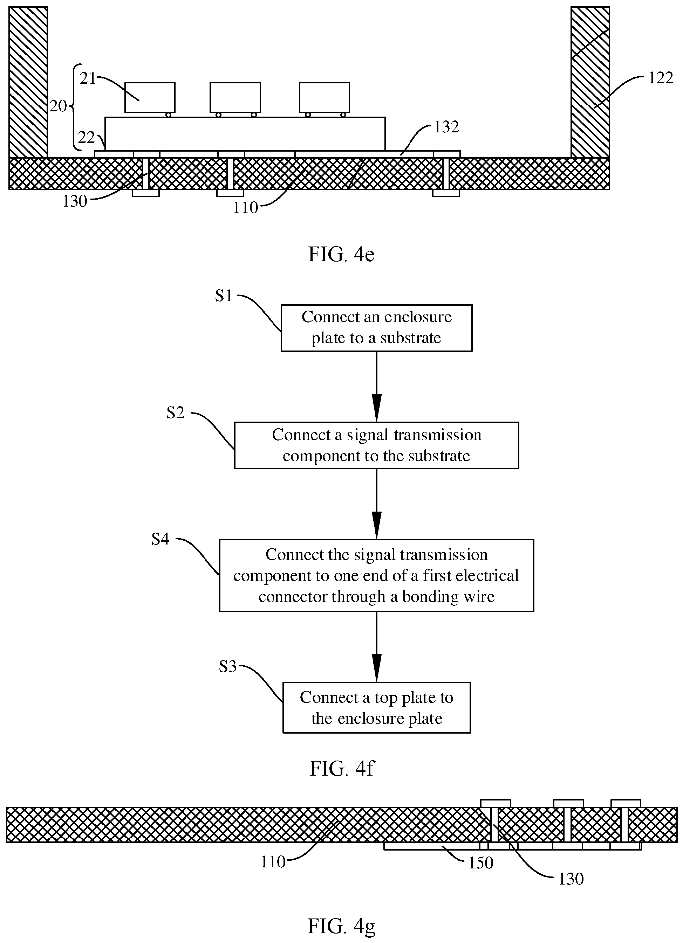

FIG. 4e is a diagram of a structure present after S2 in FIG. 4a is performed. For example, the signal transmission component 20 may be welded or bonded to the substrate 110.

S3: Connect a top plate 121 to the enclosure plate 122.

For example, the top plate 121 may be welded to the enclosure plate 122. FIG. 2c is a diagram of a structure present after S3 in FIG. 4a is performed.

In the example in FIG. 4a, S1, S2, and S3 are not subject to a specific sequence. For example, S1, S2, and S3 may be performed in sequence. Alternatively, S2, S1, and S3 may be performed in sequence, or S2, S3, and S1 may be performed in sequence.

A packaging process of the packaging assembly 10 provided in this embodiment of this application is simple, and technological process costs are low.

FIG. 4f is another assembly flowchart of the packaging assembly 10. Refer to FIG. 4a and FIG. 4f. For S1, S2, and S3 in FIG. 4f, refer to FIG. 4a. Details are not described herein again.

In the example in FIG. 4f, a structure of a substrate 110 present before S1 is performed is shown in FIG. 4g. Before S1, a first electrical connector 130 and a second wiring layer 150 have been prefabricated on the substrate 110.

In FIG. 4f, after S2, the following is further included.

S4: Connect a signal transmission component 20 to one end of the first electrical connector 130 through a bonding wire 131.

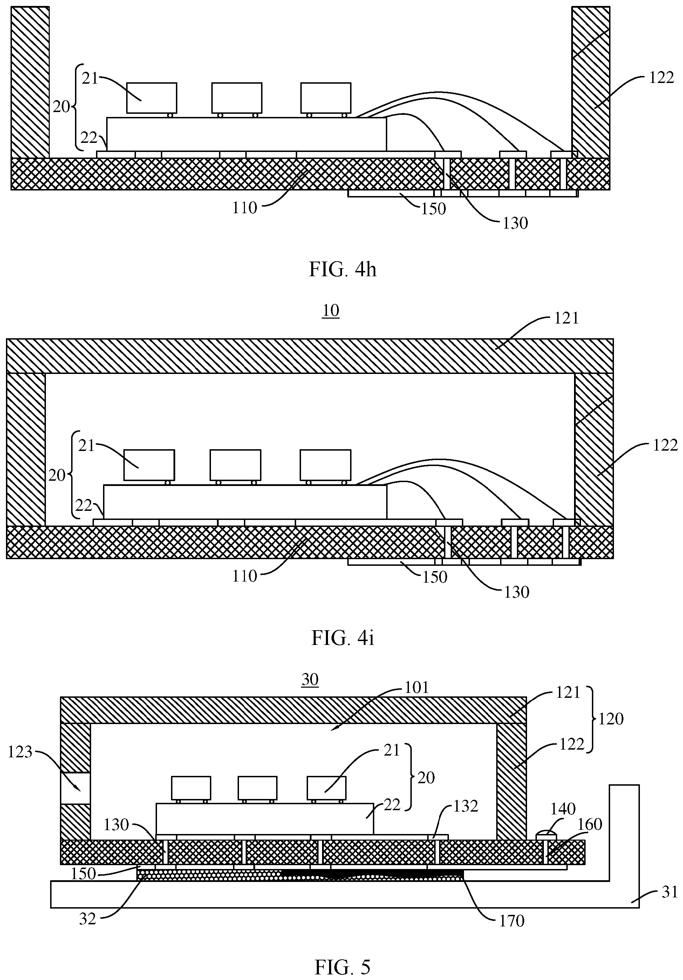

FIG. 4h is a diagram of a structure present after S4 in FIG. 4f is performed. FIG. 4i is a diagram of a structure present after S3 in FIG. 4f is performed.

Based on the assembly flowchart provided in this embodiment of this application, the packaging assembly 10 with good air tightness may be obtained. An assembly process is simple.

The following describes an example in which the tube-housing packaging member 100 is used in a lidar transmit module.

FIG. 5 is a diagram of a structure of a lidar transmit module 30 that includes the tube-housing packaging member 100 in FIG. 3c. Refer to FIG. 5. The lidar transmit module 30 includes the tube-housing packaging member 100, a signal transmission component 20, and a bracket 31. The bracket 31 is connected to the tube-housing packaging member 100.

The signal transmission component 20 includes a component 21 and a printed circuit board 22 that are electrically connected to each other, and the component 21 is a die. A lens 123 is disposed on an enclosure plate 122. An optical signal of the die may be transmitted to outside of a sealing cavity 101 by using the lens 123.

In FIG. 5, the bracket 31 is connected to a surface that is of a substrate 110 and that is away from the sealing cavity 101. In this way, heat of the signal transmission component 20 may be transferred to the bracket 31 by using the substrate 110. This facilitates heat dissipation of the die.

In the example in FIG. 5, the bracket 31 is bonded to the substrate 110. For example, the bracket 31 may be bonded to the substrate 110 through a thermally conductive adhesive layer 32. In this way, the thermally conductive adhesive layer 32 may transfer heat of the substrate 110 to the bracket 31.

A connection manner between the bracket 31 and the substrate 110 is not limited in this embodiment of this application. For example, the bracket 31 is welded to the substrate 110.

As described above, there is an insulation layer 170 between the thermally conductive adhesive layer 32 and a second wiring layer 150. The insulation layer 170 can reduce impact of the thermally conductive adhesive layer 32 and the bracket 31 on electrical performance of the second wiring layer 150, thereby reducing impact on electrical performance of the signal transmission component 20.

A structure of the bracket 31 is not limited in this embodiment of this application, and may be set based on a use scenario of the lidar transmit module 30.

In FIG. 5, the bracket 31 and a pin 140 are located on two sides of the substrate 110, and the pin 140 avoids the bracket 31. When the lidar transmit module 30 is connected to a structure such as a power supply through the pin 140, blocking of the bracket 31 is small. This facilitates quick assembly.

In another embodiment of this application, the bracket 31 may be connected to a cover 120. For example, the bracket 31 is connected to the enclosure plate 122, or the bracket 31 is connected to a top plate 121.

The bracket 31 is connected to the cover 120, and the bracket 31 may avoid the substrate 110. This is conducive to connecting the substrate 110 and a first electrical connector 130 or a second electrical connector 160 on a surface of the substrate 110 to another component. In addition, the insulation layer 170 may not be disposed between the bracket 31 and the cover 120. This may reduce costs.

The tube-housing packaging member 100 provided in this embodiment of this application implements signal transmission of the signal transmission component 20 by using the first electrical connector 130. The first electrical connector 130 may use electroplated copper or the like with low costs, to replace existing high-temperature co-fired ceramics, thereby reducing costs of the tube-housing packaging member 100. In addition, a thermal expansion coefficient of the substrate 110 is the same as a thermal expansion coefficient of the signal transmission component 20, so that internal stress between the substrate 110 and the signal transmission component 20 caused by a temperature change can be reduced, and mechanical performance reliability can be improved. The substrate 110 provides excellent heat dissipation performance for the signal transmission component 20. Further, the substrate 110 may be made of a material such as ceramics, and in comparison with a WCu alloy, costs of the tube-housing packaging member 100 may be further reduced.

Apparently, costs of a packaging assembly 10 obtained by packaging the signal transmission component 20 by the tube-housing packaging member 100 are reduced, and mechanical performance is reliable. Excellent heat transfer performance and sealing performance of the tube-housing packaging member 100 well ensure electrical performance reliability of the signal transmission component 20.

The foregoing descriptions are merely specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

## Claims

1. A tube-housing packaging member, wherein the tube-housing packaging member is configured to package a signal transmission component, and the tube-housing packaging member comprises:
a cover;
a substrate, wherein the substrate is configured to be connected to the cover, to enclose a sealing cavity, the substrate is configured to be connected to the signal transmission component located in the sealing cavity, and a thermal expansion coefficient of the substrate is the same as a thermal expansion coefficient of the signal transmission component; and
a first electrical connector, wherein the first electrical connector penetrates the substrate, one end of the first electrical connector is configured to be electrically connected to the signal transmission component, and the other end is located outside the sealing cavity.

2. The tube-housing packaging member according to claim 1, wherein the signal transmission component comprises a printed circuit board and a component that are electrically connected to each other, the substrate is configured to be connected to the printed circuit board, one end of the first electrical connector is configured to be electrically connected to the printed circuit board, and the thermal expansion coefficient of the substrate is the same as a thermal expansion coefficient of the printed circuit board.

3. The tube-housing packaging member according to claim 1, wherein the signal transmission component comprises a component.

4. The tube-housing packaging member according to any one of claims 1 to 3, wherein a material of the substrate comprises at least one of ceramics, glass, and a silicon wafer.

5. The tube-housing packaging member according to claim 4, wherein the ceramics comprises at least one of AlN, Al₂O₃, SiC, and SiN.

6. The tube-housing packaging member according to any one of claims 1 to 5, wherein the tube-housing packaging member further comprises a first wiring layer, the first wiring layer is connected to an inner surface of the substrate, and the first wiring layer is configured to connect the first electrical connector to the signal transmission component.

7. The tube-housing packaging member according to any one of claims 1 to 6, wherein the tube-housing packaging member further comprises a bonding wire, the bonding wire is located in the sealing cavity, and the bonding wire is configured to connect the first electrical connector to the signal transmission component.

8. The tube-housing packaging member according to any one of claims 1 to 7, wherein the tube-housing packaging member further comprises a second wiring layer, the second wiring layer is connected to an outer surface of the substrate, and the end that is of the first electrical connector and that is located outside the sealing cavity is electrically connected to the second wiring layer.

9. The tube-housing packaging member according to claim 8, wherein the tube-housing packaging member further comprises a second electrical connector, the substrate has an extension portion located outside the sealing cavity, the second electrical connector penetrates the extension portion, and the second electrical connector is electrically connected to the second wiring layer.

10. The tube-housing packaging member according to claim 8 or 9, wherein the tube-housing packaging member further comprises an insulation layer, and the insulation layer covers the second wiring layer.

11. The tube-housing packaging member according to any one of claims 1 to 10, wherein the tube-housing packaging member further comprises a lens, the lens is connected to the cover, and the lens is used to allow an optical signal of the signal transmitter to pass through.

12. The tube-housing packaging member according to any one of claims 1 to 11, wherein the cover comprises a top plate and an enclosure plate that are connected to each other, the top plate is disposed opposite to the substrate, and the substrate is connected to the enclosure plate.

13. The tube-housing packaging member according to any one of claims 1 to 12, wherein the first electrical connector is formed through electroplating, chemical plating, or sputtering.

14. A packaging assembly, wherein the packaging assembly comprises:
a signal transmission component; and
the tube-housing packaging member according to any one of claims 1 to 13, wherein the signal transmission component is located in the sealing cavity, and the signal transmission component is electrically connected to the first electrical connector; and
a thermal expansion coefficient of the signal transmission component is the same as a thermal expansion coefficient of the substrate.

15. The packaging assembly according to claim 14, wherein the signal transmission component is welded or bonded to the substrate.

16. The packaging assembly according to claim 14 or 15, wherein the packaging assembly further comprises a bracket, and the bracket is connected to the cover or the substrate.

17. The packaging assembly according to claim 16, wherein the bracket is connected to the substrate through a thermally conductive adhesive.

18. A lidar transmit module, wherein the lidar transmit module comprises the packaging assembly according to any one of claims 14 to 16.
